# FASCICULE DE BREVET EUROPEEN

(11) **EP 2 462 629 B1**
(45) Date de publication et mention de la délivrance du brevet: **30.09.2015**
(21) Numéro de dépôt: 10762725.9
(22) Date de dépôt: 30.07.2010
(51) Int. Cl.: H02S 40/44, H01L 31/0687, H01L 31/0693, H01L 31/078, H01L 31/054, H01L 31/0304, H01L 31/0392, F22B 1/00, F24J 2/07, F24J 2/14

(54) **Collecteur d'énergie solaire hybride et centrale solaire comprenant au moins un tel collecteur**
Hybrid-Sonnenenergiekollektor und Sonnenkraftwerk mit mindestens einem solchen Kollektor
Hybrid solar energy collector and solar power plant comprising at least such a collector

(30) Priorité: 03.08.2009 FR 0955460
(43) Date de publication de la demande: 13.06.2012
(73) Titulaire: AREVA, 92400 Courbevoie (FR)
(72) Inventeur: MOUSSAVI, Mehdi, 75017 Paris (FR)
(74) Mandataire: Jacobson, Claude
(86) Numéro de dépôt international: PCT/FR2010/051630
(87) Numéro de publication internationale: WO 2011/015775

(56) Documents cités:
- WO-A2-2004/099682
- JP-A- 58 031 253
- JP-A- 58 037 449
- US-A- 4 002 031
- TAKAMOTO T ET AL: "HIGH EFFICIENCY INGAP SOLAR CELLS FOR INGAP/GAAS TANDEM CELL APPLICATIONS", WORLD CONFERENCE ON PHOTOVOLTAIC ENERGY, WAIKOLOA, HI, USA, DEC. 5 - 9, 1994, 5 décembre 1994 (1994-12-05), - 9 décembre 1994 (1994-12-09), pages 1729-1732, XP000680146, IEEE, NEW YORK, NY, USA ISBN: 978-0-7803-1460-3
- YAZAWA Y ET AL: "GaInP single-junction and GaInP/GaAs two-junction thin-film solar cell structures by epitaxial lift-off", SOLAR ENERGY MATERIALS AND SOLAR CELLS, vol. 50, no. 1-4, janvier 1998 (1998-01), pages 229-235, XP004102514, ELSEVIER SCIENCE PUBLISHERS, AMSTERDAM, NL ISSN: 0927-0248
- R R KING ET AL: "NEXT-GENERATION, HIGH-EFFICIENCY Ill-V MULTIJUNCTION SOLAR CELLS", PROCEEDINGS OF 28TH IEEE PHOTOVOLTAIC SPECIALISTS CONFERENCE, 15-22 SEPTEMBRE 2000, ANCHORAGE, AK, USA, 15 September 2000 (2000-09-15), - 22 September 2000 (2000-09-22), pages 998-1001, XP055128084, DOI: 10.1109/PVSC.2000.916054

## Description

La présente invention concerne le domaine des convertisseurs d'énergie solaire hybrides.

Un collecteur d'énergie solaire « hybride » est nommé ainsi du fait qu'il convertit l'énergie solaire qu'il reçoit en différentes formes d'énergie, notamment en énergie électrique et en énergie thermique.

Il est possible de prévoir un collecteur d'énergie solaire hybride du type comprenant au moins une cellule photovoltaïque pour la conversion d'énergie solaire en énergie électrique et au moins un receveur thermique pour la conversion d'énergie solaire en énergie thermique par chauffage d'un fluide, disposé de façon à recevoir de l'énergie solaire traversant la cellule photovoltaïque.

De l'énergie solaire non convertie en énergie électrique par les cellules photovoltaïques chauffe le fluide circulant dans le conduit et est ainsi convertie en énergie thermique.

Dans le but d'améliorer le rendement énergie solaire convertie / énergie solaire reçue des cellules photovoltaïques, il a été envisagé des cellules photovoltaïques à jonctions semi-conductrices multiples superposées, dans lesquelles les jonctions semi-conductrices possèdent des bandes interdites (« bandgap » en anglais) de largeurs différentes, de sorte qu'elles convertissent l'énergie solaire en énergie électrique dans des gammes de longueur d'onde lumineuse différentes, de façon à couvrir la plus large bande spectrale du spectre solaire.

Néanmoins, ces cellules photovoltaïques présentent un coût de fabrication élevé.

WO2004/099682 divulgue un collecteur d'énergie solaire individuel comprenant une cellule photovoltaïque pour convertir l'énergie solaire en énergie électrique et un dispositif de refroidissement de la cellule photovoltaïque, permettant de récupérer la chaleur de la cellule photovoltaïque.

Néanmoins, le dispositif de refroidissement est prévu pour récupérer la chaleur de la cellule photovoltaïque par conduction thermique entre le dispositif de refroidissement et la cellule photovoltaïque. Il ne permet pas de convertir efficacement de l'énergie solaire en énergie thermique, notamment quand les applications envisagées sont du type turbine a vapeur couplée à un générateur avec des températures de fluide de travail bien supérieur à celles envisagées dans WO2004/099682.

La cellule photovoltaïque est prévue du type à « haute efficacité » à triple jonction comprenant trois jonctions semi-conductrices superposées pour convertir l'énergie solaire sur une large étendue de fréquence lumineuse.

Des cellules photovoltaïques tandem InGaP/GaAs sont décrites dans les publications « High Efficiency InGaP solar cells for InGaP/GaAs tendem cells applications », World conference on photovoltaic energy, Waikoloa, HI, USA, 5 - 9 décembre 1994, pages 1729 - 1732 et « GaInP single-junction and GaInP/GaAs two-junction thin-film solar cells structures by epitaxial lift-off », Solar energy materials and solar cells, vol.50, no. 1-4, janvier 1998, pages 229-235.

Des cellules photovoltaïques multi-jonctions sont décrites dans « Next-generation, high efficiency III-V multijonction solar cells », Proceedings of the 28th IEEE Photovoltaic Specialists Conference, 15-22 septembre 2000, Anchorage, AK, USA, pages 998-1001.

US4002031 divulgue une centrale de production d'électricité comprenant un collecteur d'énergie solaire associé à une centrale à vapeur.

Un but de l'invention est de proposer un collecteur d'énergie solaire hybride possédant un rendement satisfaisant (électrique + thermique) tout en conservant un coût de fabrication raisonnable.

Un autre but de l'invention est de proposer un collecteur d'énergie solaire hybride permettant de coupler à la partie thermique une centrale électrique à turbine à vapeur.

A cet effet, l'invention propose un collecteur d'énergie solaire hybride selon la revendication 1. Des caractéristiques optionnelles figurent aux revendications 2 à 12.

Le choix judicieux des matériaux pour la cellule photovoltaïque, ainsi que l'optimisation de leurs épaisseurs, permet de garder le maximum de transparence en infrarouge pour la conversion thermique.

L'invention concerne également une centrale de production d'électricité selon la revendication 13 ou selon la revendication 14.

L'invention et ses avantages seront mieux compris à la lecture de la description qui va suivre, donnée uniquement à titre d'exemple, et faite en référence aux dessins annexés, sur lesquels :
- la figure 1 est une vue schématique de côté d'un collecteur d'énergie solaire hybride selon l'invention ;
- la figure 2 est une vue schématique en coupe d'une cellule photovoltaïque du collecteur d'énergie solaire de la figure 1 ;
- la figure 3 est une vue schématique d'ensemble d'une centrale solaire comprenant des collecteurs d'énergie solaire selon la figure 1 ;
- la figure 4 est une vue analogue à celle de la figure 1 illustrant un collecteur d'énergie solaire suivant une variante de l'invention ;
- la figure 5 est une vue schématique en perspective d'un receveur thermique et de cellules photovoltaïques du collecteur d'énergie solaire de la figure 4,
- les figures 6 et 7 sont des vues partielles de collecteurs d'énergie solaire suivant des variantes de l'invention.

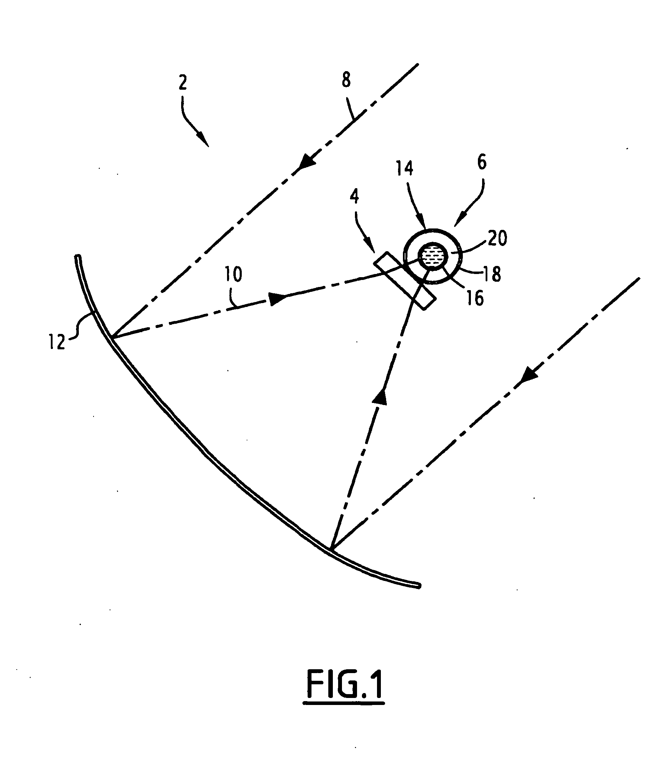

Le collecteur 2 d'énergie solaire hybride de la figure 1 permet la conversion d'énergie solaire en énergie électrique et en énergie thermique simultanément.

Le collecteur 2 comprend au moins une cellule photovoltaïque 4 pour la conversion d'énergie solaire en énergie électrique et au moins un receveur thermique 6 pour la conversion d'énergie solaire en énergie thermique par chauffage d'un fluide, disposé de façon à recevoir de l'énergie solaire traversant la cellule photovoltaïque 4.

Le collecteur 2 est du type à concentration. Il comprend des moyens de concentration d'un faisceau solaire incident 8 en un faisceau solaire concentré 10 dirigé vers les moyens de conversion d'énergie définis par la cellule photovoltaïque 4 et le receveur thermique 6

Dans l'exemple illustré, les moyens de concentration se présentent sous la forme d'un miroir 12 cylindro-parabolique orienté de façon à diriger le faisceau concentré 10 en direction des moyens de conversion d'énergie, situés de préférence sensiblement au foyer du miroir 12.

De manière connue en soi, le collecteur 2 est de préférence orientable de façon à être déplacé avec le soleil et orienté vers celui-ci.

Tel que représenté sur la figure 1, le receveur thermique 6 se présente sous la forme d'un conduit 14 à double paroi et vide intermédiaire, comprenant un tube interne 16 de circulation d'un fluide et un tube externe 18 entourant le tube interne 16, un espace annulaire 20 d'isolation étant délimité entre les tubes interne 16 et externe 18. Un vide au moins partiel est créé dans l'espace annulaire 20 de façon à limiter les pertes thermiques vers l'extérieur.

Alternativement, le receveur thermique peut être constitué d'un simple tube en acier et/ou d'un faisceau de tubes en acier.

En fonctionnement, le faisceau lumineux concentré 10 est reçu par la cellule photovoltaïque 4 qui convertit une partie de l'énergie solaire en énergie électrique. Une partie du faisceau lumineux concentré 10 traverse la cellule photovoltaïque 4 et atteint le receveur thermique 6 qui convertit au moins une partie de l'énergie solaire qu'il reçoit en énergie thermique par chauffage du fluide circulant dans le receveur thermique 6.

Le fluide circulant dans le receveur thermique 6 est chauffé notamment par les rayonnements infrarouges (rayonnements IR) traversant la cellule photovoltaïque 4 et le conduit 14

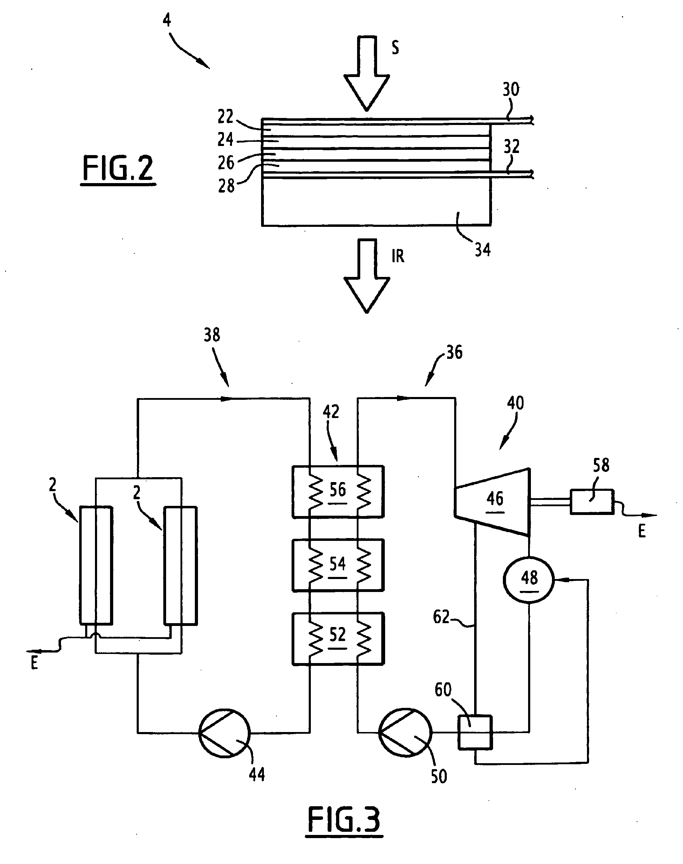

Tel qu'illustré sur la figure 2, la cellule photovoltaïque 4 est une cellule photovoltaïque à jonctions semi-conductrices multiples comprenant plusieurs jonctions semi-conductrices superposées.

Les jonctions semi-conductrices possèdent des bandes interdites (« bandgap » en anglais) de largeurs différentes.

Une jonction semi-conductrice convertit les rayonnements lumineux dont les photons se situent dans une gamme d'énergie supérieure à la largeur de bande interdite de la jonction semi-conductrice.

L'énergie d'un photon s'exprime en électronvolts (eV) et est sensiblement inversement proportionnelle à la longueur d'onde lumineuse correspondante généralement exprimée en nanomètre (nm).

Ainsi, une jonction semi-conductrice convertit les rayonnements lumineux en électricité dans une gamme de longueur d'ondes inférieures à celle correspondant à sa largeur de bande interdite, et ne convertit pas les rayonnements lumineux dans une gamme de longueur d'ondes supérieures à celle correspondant à sa largeur de bande interdite.

Les jonctions semi-conductrices possédant des bandes interdites de largeurs différentes convertissent donc les rayonnements lumineux en énergie électrique dans des gammes de longueur d'onde différentes. L'association de jonctions semi-conductrices possédant des bandes interdites de largeurs différentes permet donc une conversion d'énergie lumineuse dans une gamme de longueur d'ondes étendue.

Selon un aspect de l'invention, les jonctions semi-conductrices de la cellule photovoltaïque 4 possèdent toutes une largeur de bande interdite égale ou supérieure à 1,2 eV, notamment égale ou supérieure à 1,4 eV.

Ainsi, les jonctions semi-conductrices ne convertissent pas les rayonnements lumineux de longueurs d'ondes égales ou supérieures à 1033 nm, notamment égales ou supérieures à 885 nm.

Les jonctions semi-conductrices permettent donc de limiter l'absorption des rayonnements IR situés dans la gamme de longueurs d'ondes supérieures à 780 nm.

Ces rayonnements IR traversant la cellule photovoltaïque 4 sont reçus par le receveur thermique 6 (figure 1) et permettent un chauffage efficace du fluide circulant dans le receveur thermique 6.

Au lieu convertir les rayonnements solaires en énergie électrique dans la gamme de longueur d'onde la plus large possible, l'invention propose donc d'utiliser les rayonnements de longueurs d'onde élevées pour une conversion en énergie électrique et d'utiliser les rayonnements de longueur d'onde plus faibles, en particulier dans la gamme des IR, pour une conversion en énergie thermique, dans laquelle ils sont efficaces.

Cette répartition permet un rendement satisfaisant, et permet l'obtention d'une cellule photovoltaïque simple et de coût faible.

Avantageusement, la cellule photovoltaïque 4 est composée de couches semi-conductrices à base de matériaux III-V comprenant au moins un composé de la colonne III du tableau de Mendeleïev et au moins un composé du groupe V du tableau de Mendeleïev. Ces matériaux sont binaires, ternaires, quaternaires...en fonction du nombre de composé des colonnes III et V.

Avantageusement encore, la cellule photovoltaïque 4 comprend au moins une couche semi-conductrice en GaAs et/ou au moins une couche semi-conductrice en GaInP ou GaInP2, qui sont des matériaux de coût raisonnable permettant d'obtenir des jonctions semi-conductrices de largeur de bande interdite appropriées.

Dans l'exemple illustré, la cellule photovoltaïque 4 est du type à double jonction GaAs/GaInP et comprend une première jonction GaAs formée par deux couches semi-conductrices GaAs 22, 24 superposées et dopées différemment (par ex. l'une n et l'autre p), et une deuxième jonction GaInP formée par deux couches semi-conductrices GaInP 26, 28 superposées et dopées différemment (par ex. l'une n et l'autre p).

Avantageusement, les couches semi-conductrices GaAs 24 et GaInP 26 adjacentes sont liées de façon qu'elles forment en outre une hétérojonction GaAs/GaInP.

La première jonction semi-conductrice GaAs (ou homojonction GaAs) a une largeur de bande interdite d'environ 1,43 eV, la deuxième jonction semi-conductrice GaInP (ou homojonction GaInP) a une largeur de bande interdite d'environ 1,84 eV, et l'hétérojonction semi-conductrice GaAs/GaInP est ainsi capable de convertir en électricité les longueurs d'ondes du rayonnement solaire inférieures aux bandes interdites des deux homojonctions.

L'association de ces jonctions semi-conductrices permet une conversion efficace de l'énergie solaire en énergie électrique dans un spectre large, tout en permettant le passage des rayonnements IR.

En particulier, la cellule photovoltaïque 4 est dépourvue de couche semi-conductrice de Germanium (Ge) qui absorberait les rayonnements IR et qui s'avère en outre coûteuse.

De manière connue, de part et d'autre de l'empilement des couches semi-conductrices 22, 24, 26, 28 la cellule photovoltaïque comprend des électrodes 30, 32 pour collecter les charges électriques.

D'autres agencements de couches semi-conductrices et de jonctions semi-conductrices sont envisageables.

De préférence, afin de favoriser la transparence de la cellule aux rayonnements IR, les couches semi-conductrices sont des couches minces. Elles possèdent par exemple une épaisseur comprise entre 1 et 20 µm, notamment entre 1 et 10 µm. De telles couches semi-conductrices minces sont obtenues par exemple, de manière connue, par transfert ou croissance par épitaxie sur un substrat 34, de manière à minimiser les dislocations ou autres défauts à l'interface des couches semi-conductrices.

De préférence, le substrat 34 est constitué d'un matériau choisi pour sa transparence aux IR. Le substrat est par exemple en verre transparent aux infrarouges.

L'efficacité d'une cellule photovoltaïque décroît à partir d'une certaine température, avec un taux de décroissance qui dépend de la ou des jonctions qui la compose.

Afin d'assurer le fonctionnement de la cellule photovoltaïque 4 et du receveur thermique 6 dans des plages de températures satisfaisantes, le facteur de concentration des moyens de concentration du collecteur 2 est de préférence compris en 80 et 120, notamment environ égal à 100.

On notera que la cellule photovoltaïque 4 favorisant le passage des rayonnements IR permet de travailler avec des facteurs de concentration élevés tout en limitant l'échauffement thermique de la cellule photovoltaïque.

Tel qu'illustré sur la figure 3, la centrale solaire 36 comprend un premier circuit 38 de circulation d'un fluide thermique et un deuxième circuit 40 de circulation d'un fluide de travail, et des moyens d'échange thermique 42 entre le fluide thermique et le fluide de travail.

Le fluide thermique est par exemple une huile de synthèse pouvant atteindre des températures élevées, de l'ordre de 250°C à 400°C sans évaporation. Le fluide de travail est par exemple de l'eau.

Le premier circuit 38 comprend en série une pompe 44 de circulation du fluide thermique et un champ de collecteurs 2 d'énergie solaire tels qu'illustrés aux figures 1 et 2. Les collecteurs 2 sont disposés en parallèle.

Le deuxième circuit 40 comprend en série une turbine à vapeur 46 (qui est entraînée par le fluide de travail à l'état vapeur), un condenseur 48 et une pompe de circulation 50.

Les moyens d'échange thermique 42 comprennent un préchauffeur 52, un évaporateur 54 et un surchauffeur 56, traversé en ordre inverse par le premier circuit 38 et le deuxième circuit 40 : le premier circuit 38 traverse successivement le surchauffeur 56, l'évaporateur 54 et le préchauffeur 52, tandis que le deuxième circuit 40 traverse successivement le préchauffeur 52, l'évaporateur 54 et le surchauffeur 56.

La turbine 46 est couplée à un générateur électrique 58.

En option, de manière connue, le deuxième circuit 40 comprend un ou plusieurs préchauffeurs 60 reliés à des piquages 62 intermédiaires de la turbine 46 et au condenseur 48.

En fonctionnement, le fluide thermique circule dans le premier circuit 38 et est chauffé dans les collecteurs, jusqu'à une température pouvant atteindre 250°C à 400°C. En passant dans les moyens d'échange thermique 42, il cède des calories au fluide de travail. Le fluide de travail est successivement préchauffé, évaporé puis surchauffé dans le préchauffeur 52, l'évaporateur 54 et le surchauffeur 56.

Dans la turbine à vapeur 46, le fluide de travail se détend en se refroidissant et entraîne en rotation l'arbre de sortie de la turbine 46. Celle-ci est couplée à un générateur électrique 58 pour produire de l'énergie électrique.

La centrale solaire 36 permet ainsi de convertir l'énergie solaire en énergie électrique. Une partie de l'énergie solaire est convertie directement en énergie électrique par les collecteurs 2, tandis qu'une autre partie de l'énergie solaire est convertie en énergie thermique par les collecteurs 2 avant d'être convertie en énergie mécanique (turbine 46) puis électrique (générateur 58).

La centrale solaire 36 munie des collecteurs 2 permet l'obtention d'un rendement élevé en optimisant la part d'énergie solaire qui est convertie directement en énergie électrique par les cellules photovoltaïques et celle qui sert à chauffer le fluide thermique.

D'autres types de centrales solaires peuvent utiliser les collecteurs 2. Par exemple, dans une centrale solaire, le fluide thermique peut faire office également de fluide de travail et être utilisé directement dans une turbine à vapeur sans prévoir de circuits séparés couplés par des échangeurs de chaleur intermédiaires.

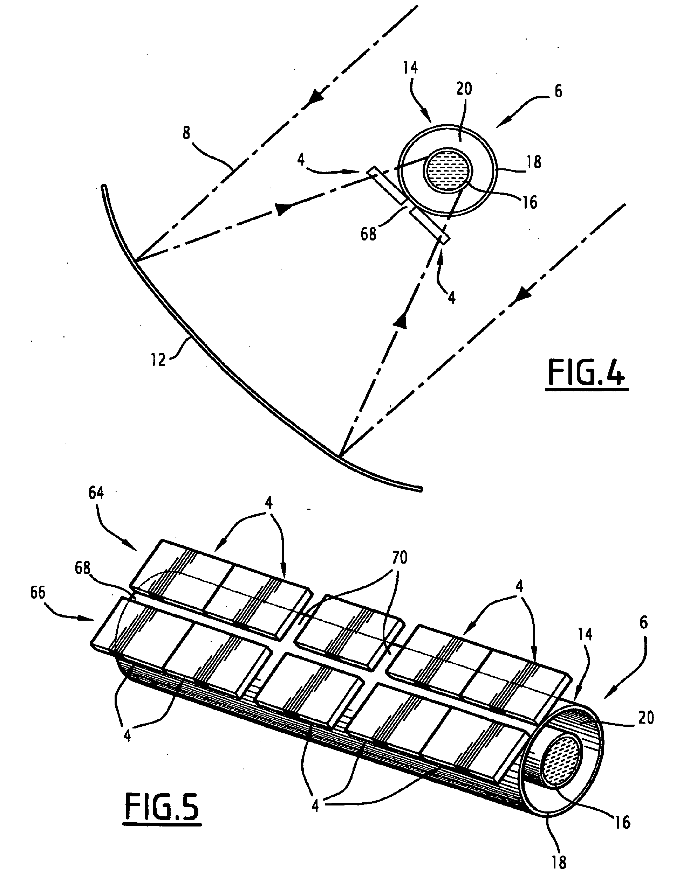

Tel que représenté sur les figures 4 et 5, où les références aux éléments analogues à ceux de la figure 1 ont été reprises, le collecteur 2 diffère de celui de la figure 1 en ce qu'il comprend des cellules photovoltaïques 4 disposées le long du receveur thermique 6 de sorte qu'une partie de l'énergie solaire atteigne le receveur thermique 6 en étant filtrée par les cellules photovoltaïques 4 et l'autre partie de l'énergie solaire atteigne directement le receveur thermique 6 par au moins une ouverture 68, 70 ménagée entre les cellules photovoltaïques 4.

Tel que représenté sur les figures 4 et 5, le receveur thermique 6 est allongé suivant une direction perpendiculaire au plan de la figure 4, et le collecteur 2 comprend deux séries 64, 66 de cellules photovoltaïques 4 réparties le long du receveur thermique 6. Chaque cellule photovoltaïque 4 d'une série est longitudinalement en regard d'une cellule photovoltaïque 4 de l'autre série.

Les cellules photovoltaïques 4 d'une série sont espacées transversalement des cellules photovoltaïques 4 de l'autre série, de sorte que les cellules photovoltaïques 4 définissent entre une ouverture longitudinale 68 s'étendant le long du receveur thermique 4.

Tel que représenté sur la figure 5, des cellules photovoltaïque 4 sont espacées longitudinalement de sorte que des ouvertures transversales 70 sont définies entre les cellules photovoltaïques 4. Les ouvertures transversales 70 sont telles que dans le plan transversal passant par chaque ouverture transversale 70, l'ensemble du faisceau lumineux atteint directement le receveur thermique 6 sans être filtré par les cellules photovoltaïques 4.

Ce mode de réalisation permet d'avoir un receveur thermique de forte dimension, en particulier de fort diamètre, tout en conservant des cellules photovoltaïques de dimensions réduites. Ceci permet de limiter le coût des cellules photovoltaïques dont le prix augmente fortement avec la surface.

Les ouvertures transversales 70 permettent de laisser des bandes transversales du receveur thermique 6 recevoir un flux solaire complet ce qui peut être avantageux dans le bilan thermique du receveur thermique 6, sans pour autant diminuer la performance des cellules photovoltaïques 4.

Les ouvertures 68, 70 entre les cellules photovoltaïques 4 améliorent le refroidissement par convexion naturelle des cellules photovoltaïques 4. Or il est connu que la performance des cellules photovoltaïques décroit avec la montée en température. Cette convection naturelle améliorée permet de maintenir ou d'augmenter la performance de cellules photovoltaïques par rapport à un dispositif où les cellules photovoltaïques ne seraient pas espacées.

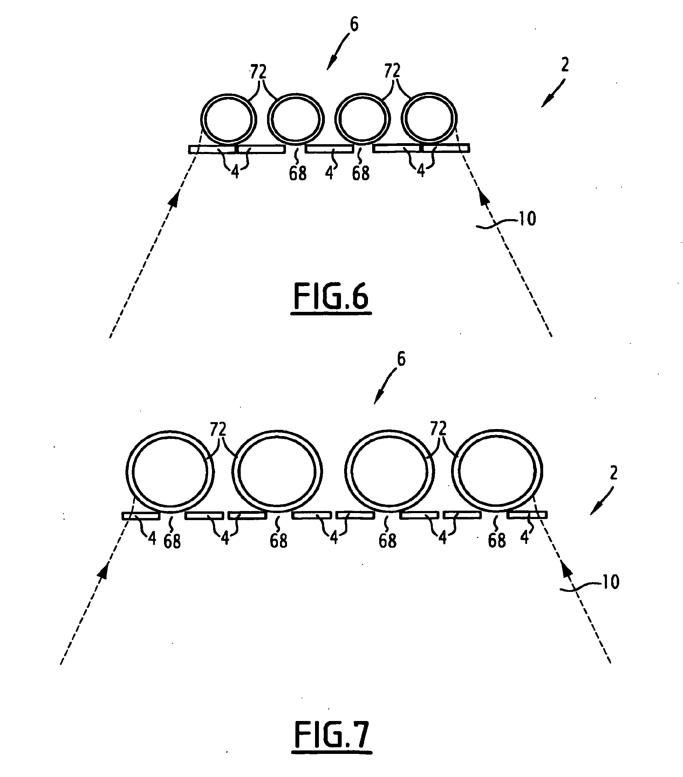

Le collecteur 2 illustré sur la figure 6 diffère des modes de réalisation précédents en ce que le receveur thermique 6 comprend un faisceau de conduits 72 parallèles.

Les conduits 72 sont à simple paroi. Ils sont par exemple réalisés en acier. En variante, les conduits 72 sont à double paroi avec vide intermédiaire.

Les conduits 72 sont disposés de façon à recevoir le faisceau lumineux concentré 10 traversant les cellules photovoltaïques 4 conformément à l'invention.

Le collecteur 2 comprend plusieurs séries de cellules photovoltaïques 4. Chaque série de cellules photovoltaïques 4 comprend une pluralité de celles réparties le long des conduits 72 suivant la direction d'extension des conduits 72 (perpendiculaire au plan de la figure 6). Les séries sont réparties transversalement à la direction d'extension des conduits 72.

En option, et comme représenté sur la figure 6, certaines cellules photovoltaïques sont espacées et définissent entre elles des ouvertures longitudinales 68. Dans l'exemple illustré, le collecteur 2 comprend quatre conduits 72 parallèles et cinq séries de cellules photovoltaïques 4 réparties transversalement et définissant entre elles deux ouvertures longitudinales 68.

Le collecteur 2 illustré sur la figure 7 diffère de celui de la figure 6 en ce qu'il comprend pour chaque conduit 72 deux séries de cellules photovoltaïques 4 définissant entre elles une ouverture longitudinale 68.

Les conduits présentent en outre des diamètres supérieurs.

Par ailleurs, l'invention n'est pas limitée à des collecteurs comprenant des moyens de concentration sous la forme d'un miroir cylindro-parabolique.

En variante, un collecteur selon l'invention comprend des moyens de concentration sous la forme de miroirs de Fresnel. Des champs de miroirs de Fresnel associés à différents receveurs peuvent être imbriqués pour définir un réflecteur de Fresnel linéaire compact (« Compact Linear Fresnel Reflector » - « CLFR » en anglais).

Les différents types de moyens de concentration, de receveur et d'agencement des moyens de concentrations et des receveurs évoquées ci-dessus peuvent être combinés.

Ainsi, l'invention s'applique à une centrale telle que divulguée dans WO2009/029277, comprenant des collecteurs d'énergie solaire linéaires combinant des moyens de concentration à miroirs de Fresnel imbriqués et des receveurs thermiques à faisceaux de conduits parallèles.

## Revendications

1. Collecteur (2) d'énergie solaire hybride, du type comprenant au moins une cellule photovoltaïque (4) pour la conversion d'énergie solaire en énergie électrique et au moins un receveur thermique (6) pour la conversion d'énergie solaire en énergie thermique par chauffage d'un fluide, le receveur thermique (6) étant disposé de façon à recevoir de l'énergie solaire traversant la cellule photovoltaïque (4), la cellule photovoltaïque (4) comprenant plusieurs jonctions semi-conductrices superposées ayant des bandes interdites de largeurs différentes, chaque jonction semi-conductrice ayant une largeur de bande interdite égale ou supérieure à 1,2 eV, notamment égale ou supérieure à 1,4 eV.

2. Collecteur d'énergie solaire selon la revendication 1, dans lequel la cellule photovoltaïque comprend au moins une couche semi-conductrice (22, 24) en GaAs.

3. Collecteur d'énergie solaire selon l'une quelconque des revendications 1 et 2, dans lequel la cellule photovoltaïque comprend au moins une couche semi-conductrice (26, 28) en GaInP ou GaInP2.

4. Collecteur d'énergie solaire selon l'une quelconque des revendications précédentes, dans lequel les jonctions semi-conductrices de la cellule photovoltaïque sont formées par des couches semi-conductrices (22, 24, 26, 28) minces d'épaisseur comprise entre 1 et 20 µm, notamment entre 1 et 10 µm.

5. Collecteur d'énergie solaire selon la revendication 4, dans lequel les couches semi-conductrices (22, 24, 26, 28) sont formées sur un substrat (34).

6. Collecteur d'énergie solaire selon la revendication 5, dans lequel le substrat (34) est en un matériau choisi entre le verre ou un matériau céramique transparent aux infrarouges.

7. Collecteur d'énergie solaire selon l'une quelconque des revendications précédentes, comprenant des moyens de concentration (12) d'un faisceau solaire incident (8) pour former un faisceau solaire concentré (10) en direction de la cellule photovoltaïque (4) et du receveur thermique (6).

8. Collecteur d'énergie solaire selon la revendication 7, dans lequel le facteur de concentration des moyens de concentration (12) est compris entre 80 et 120, notamment environ égal à 100.

9. Collecteur d'énergie solaire selon l'une quelconque des revendications précédentes, comprenant plusieurs cellules photovoltaïques (4) telles que définies dans l'une quelconque des revendications 1 à 6, les cellules photovoltaïques définissant entre elles au moins une ouverture (68, 70) de sorte qu'une partie de l'énergie solaire atteigne le receveur thermique (6) en traversant les cellules photovoltaïques (4) et l'autre partie de l'énergie solaire atteigne le receveur thermique (6) en traversant la ou chaque ouverture (68, 70).

10. Collecteur d'énergie solaire selon la revendication 9, dans lequel, le receveur thermique (6) étant allongé, le collecteur d'énergie solaire comprend au moins une ouverture longitudinale (68) s'étendant longitudinalement le long du receveur thermique (6) en étant délimitée entre des cellules photovoltaïques (4) espacées transversalement entre elles.

11. Collecteur d'énergie solaire selon l'une quelconque des revendications 9 et 10, dans lequel, le receveur thermique (6) étant allongé, le collecteur d'énergie solaire comprend au moins une ouverture transversale (70) délimitée entre des cellules photovoltaïques (4) espacées longitudinalement entre elles.

12. Collecteur d'énergie solaire selon l'une quelconque des revendications précédentes, dans lequel le receveur thermique (6) comprend un faisceau de conduits (72) parallèles pour la canalisation du fluide.

13. Centrale (36) de production d'électricité comprenant au moins un collecteur (2) d'énergie solaire selon l'une quelconque des revendications précédentes.

14. Centrale selon la revendication 13, comprenant un circuit (38) de circulation d'un fluide thermique raccordé au collecteur (2) d'énergie solaire, une centrale à vapeur comprenant au moins une turbine à vapeur (46), un circuit (40) de circulation d'un fluide de travail raccordé à la centrale à vapeur, et des moyens d'échange thermique (42) entre le circuit (38) de circulation du fluide thermique et le circuit (40) de circulation du fluide de travail.

## Patentansprüche

1. Hybridsonnenenergiekollektor (2), der Art, die mindestens eine Solarzelle (4) zur Umwandlung von Sonnenenergie in elektrische Energie und mindestens einen Wärmeaufnehmer (6) für die Umwandlung von Solarenergie in Wärmeenergie durch Aufheizen eines Fluids umfasst, wobei der Wärmeaufnehmer (6) so angeordnet ist, dass er die Sonenenergie aufnimmt, die die Solarzelle (4) durchquert, wobei die Solarzelle (4) mehrere übereinander angeordnete Halbleiterübergänge umfasst, die Bandlücken unterschiedlicher Breite aufweisen, wobei jeder Halbleiterübergang eine Bandlückenbreite gleich oder größer als 1,2 eV, insbesondere gleich oder über 1,4 eV aufweist.

2. Sonnenenergiekollektor nach Anspruch 1, bei dem die Solarzelle mindestens eine Halbleiterschicht (22, 24) aus GaAs aufweist.

3. Sonnenenergiekollektor nach einem beliebigen der Ansprüche 1 und 2, bei dem die Solarzelle mindestens eine Halbleiterschicht (26, 28) aus GaInP oder GaInP2 aufweist.

4. Sonnenenergiekollektor nach einem beliebigen der vorhergehenden Ansprüche, bei dem die Halbleiterübergänge der Solarzelle durch dünne Halbleiterschichten (22, 24, 26, 28) gebildet werden, deren Dicke zwischen 1 und 20 µm, insbesondere zwischen 1 und 10 µm liegt.

5. Sonnenenergiekollektor nach Anspruch 4, bei dem die Halbleiterschichten (22, 24, 26, 28) auf einem Substrat (34) gebildet sind.

6. Sonnenenergiekollektor nach Anspruch 5, bei dem das Substrat (34) ein Material ist, das ausgewählt ist aus Glas oder einem für Infrarotstrahlung transparentes Keramikmaterial.

7. Sonnenenergiekollektor nach einem beliebigen der vorhergehenden Ansprüche, der Mittel (12) zum Konzentrieren eines einfallenden Sonnenstrahlbündels (8) aufweist, um ein konzentriertes Sonnenstrahlbündel (10) in Richtung der Solarzelle (4) und des Wärmeaufnehmers (6) zu bilden.

8. Sonnenenergiekollektor nach Anspruch 7, bei dem der Konzentrationsfaktor der Mittel (12) zum Konzentrieren zwischen 80 und 120 liegt, insbesondere ungefähr 100 ist.

9. Sonnenenergiekollektor nach einem beliebigen der vorhergehenden Ansprüche, mehrere Solarzellen (4), wie sie in einem beliebigen der Ansprüche 1 bis 6 definiert sind, umfassend, wobei die Solarzellen zwischen sich mindestens eine Öffnung (68, 70) begrenzen, derart, dass ein Teil der Sonnenergie den Wärmeaufnehmer (6) erreicht, wobei sie die Solarzellen (4) durchquert und der andere Teil der Sonnenenergie den Wärmeaufnehmer (6) erreicht, wobei sie die oder jede Öffnung (68, 70) durchquert.

10. Sonnenenergiekollektor nach Anspruch 9, bei dem der Wärmeaufnehmer (6) langgestreckt ist, wobei der Sonnenergiekollektor mindestens eine Längsöffnung (68) aufweist, die sich in Längsrichtung entlang des Wärmeaufnehmers (6) erstreckt, wobei sie durch die Solarzellen (4) begrenzt ist, die in Querrichtung voneinander beabstandet sind.

11. Sonnenenergiekollektor nach einem beliebigen der Ansprüche 9 und 10, bei dem der Wärmeaufnehmer (6) langgestreckt ist und der Sonnenenergiekollektor mindestens eine Queröffnung (70) umfasst, die zwischen den Solarzellen (4) begrenzt ist, die in Längsrichtung voneinander beabstandet sind.

12. Sonnenenergiekollektor nach einem beliebigen der vorhergehenden Ansprüche, bei dem der Wärmeaufnehmer (6) ein Bündel von parallelen Leitungen (72) für die Kanalisation des Fluids umfasst.

13. Anlage (36) zur Erzeugung von Elektrizität, mindestens einen Sonnenenergiekollektor (2) nach einem beliebigen der vorhergehenden Ansprüche umfassend.

14. Anlage nach Anspruch 13, einen Kreis (38) zur Zirkulation eines Wärmefluids, der mit dem Sonnenenergiekollektor (2) verbunden ist, eine Dampfstation mit mindestens einer Dampfturbine (46), einen Kreis (40) zur Zirkulation eines Arbeitsfluids, der an die Dampfstation angeschlossen ist, und Wärmetauschermittel (42) zwischen dem Kreis (38) zur Zirkulation des Wärmefluids und dem Kreis (40) zur Zirkulation des Arbeitsfluids umfassend.

## Claims

1. A hybrid solar energy collector, of the type comprising at least one photovoltaic cell (4) for the conversion of solar energy into electric energy and at least one thermal receiver (6) for the conversion of solar energy into heat energy by heating a fluid, the thermal receiver (6) being arranged so as to receive solar energy passing through the photovoltaic cell (4), the photovoltaic cell (4) comprising several superimposed semiconductor junctions having different forbidden energy band widths, each semiconductor junction having a forbidden energy band equal to or greater than 1.2 eV, in particular equal to or greater than 1.4 eV.

2. The solar energy collector according to claim 1, wherein the photovoltaic cell comprises at least one GaAs semiconductor layer (22, 24).

3. The solar energy collector according to claim 1 or 2, wherein the photovoltaic cell comprises at least one GaInP or GaInP2 semiconductor layer (26, 28).

4. The solar energy collector according to any one of the preceding claims, wherein the semiconductor junctions of the photovoltaic cell are formed by fine semiconductor layers (22, 24, 26, 28) having a thickness comprised between 1 and 20 µm, in particular between 1 and 10 µm.

5. The solar energy collector according to claim 4, wherein the semiconductor layers (22, 24, 26, 28) are formed on a substrate, in particular using a transfer or epitaxy method.

6. The solar energy collector according to claim 5, wherein the substrate is made from a material chosen between glass or an infrared-transparent ceramic.

7. The solar energy collector according to any one of the preceding claims, comprising means (12) for concentrating an incident solar beam (8) to form a concentrated solar beam (10) toward the photovoltaic cell (4) and the thermal receiver (6).

8. The solar energy collector according to claim 7, wherein the concentration factor of the concentration means is comprised between 80 and 120, in particular approximately equal to 100.

9. The solar energy collector according to any one of the preceding claims, comprising several photovoltaic cells as defined in any one of claims 1 - 6, the photovoltaic cells defining at least one opening (68, 70) between them so that part of the solar energy reaches the thermal receiver (6) through the photovoltaic cells (4) and on the other hand the solar energy reaches the thermal receiver (6) through the or each opening (68, 70).

10. The solar energy collector according to claim 9, wherein, the thermal receiver (6) being elongated, the solar energy collector comprises at least one longitudinal opening (68) extending longitudinally along the thermal receiver (6) while being delimited between photovoltaic cells (4) spaced transversely away from one another.

11. The solar energy collector according to claim 9 or 10, wherein, the thermal receiver (6) being elongated, the solar energy collector comprises at least one transverse opening (68) delimited between photovoltaic cells (4) spaced longitudinally away from one another.

12. The solar energy collector according to any one of the preceding claims, wherein the thermal receiver (6) comprises a bundle of parallel conduits (72) for channeling the fluid.

13. An electricity-producing solar power plant comprising at least one solar energy collector according to any one of the preceding claims.

14. The power plant according to claim 13, comprising a circuit (38) for the circulation of the coolant connected to the solar energy collector (2), a steam power station comprising at least one steam turbine (46), a circuit (40) for the circulation of a working fluid connected to the steam power station, and at least one heat exchanger (42) between the circulation circuit (38) for the coolant and the circulation circuit (40) for the working fluid.
